Europäisches Patentamt

European Patent Office

Office européen des brevets

(11) Veröffentlichungsnummer: **0 333 250**
**A2**

# (12) EUROPÄISCHE PATENTANMELDUNG

(21) Anmeldenummer: 89200546.3

(22) Anmeldetag: 06.03.89

(51) Int. Cl.⁴: **G01R 33/20**

(30) Priorität: 12.03.88 DE 3808281

(43) Veröffentlichungstag der Anmeldung:
20.09.89 Patentblatt 89/38

(84) Benannte Vertragsstaaten:
DE FR GB NL

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB NL**

(72) Erfinder: **Kunz, Dietmar Wilhelm, Dr.**
**Berliner Strasse 10**
**D-2085 Quickborn(DE)**

(74) Vertreter: **Hartmann, Heinrich, Dipl.-Ing. et al**
**Philips Patentverwaltung GmbH**
**Wendenstrasse 35 Postfach 10 51 49**
**D-2000 Hamburg 1(DE)**

(54) **Verfahren zur Bestimmung der Kernmagnetisierungsverteilung und Anordnung zur Durchführung des Verfahrens.**

(57) Die Erfindung bezieht sich auf ein Verfahren zur Bestimmung der Kernmagnetisierungsverteilung, bei dem in Anwesenheit eines homogenen stationären Magnetfeldes mehrere Sequenzen auf einen Untersuchungsbereich einwirken, wobei jede Sequenz einen Hochfrequenzimpuls enthält, durch den in Verbindung mit einem magnetischen Gradientenfeld die Kernmagnetisierung in den beiderseits einer zu untersuchenden Schicht befindlichen Bereichen angeregt und ggf. dephasiert wird. Dabei ist eine Verringerung der Hochfrequenzspitzenleistung dadurch erreichbar, daß auf einen Träger dessen Frequenz der Larmorfrequenz in der Mitte der zu untersuchenden Schicht entspricht, ein Signal moduliert wird, dessen Frequenz sich in einem Bereich ändert, der der Differenz zwischen dieser Larmorfrequenz und den Larmorfrequenzen in einem der Bereiche entspricht.

Fig.4a    Fig.4b

## Verfahren zur Bestimmung der Kernmagentisierungsverteilung und Anordnung zur Durchführung des Verfahrens

Die Erfindung betrifft ein Verfahren zur Bestimmung der Kernmagnetisierungsverteilung, bei dem in Anwesenheit eines homogenen stationären Magnetfeldes mehrere Sequenzen auf einen Untersuchungsbereich einwirken, wobei jede Sequenz einen Hochfrequenzimpuls enthält, durch den in Verbindung mit einem magnetischen Gradientenfeld die Kernmagnetisierung in den beiderseits einer zu untersuchenden Schicht befindlichen Bereichen angeregt und ggf. dephasiert wird, sowie eine Anordnung zur Durchführung dieses Verfahrens.

Ein solches Verfahren und eine solche Anordnung sind aus der DE-OS 36 04 281 bekannt. Dabei kann mit einem oder mit zwei aufeinander folgenden Hochfrequenzimpulsen in Verbindung mit einem magnetischen Gradientenfeld, die Kernmagnetisierung in den Bereichen beiderseits einer zu untersuchenden Schicht angeregt und dephasiert werden.

Bei dem benannten Verfahren wird ein amplitudenmodulierter Hochfrequenzimpuls dadurch erzeugt, daß in einem Modulator in an sich bekannter Weise, die Schwingungen eines Oszillators mit einem Hüllkurvensignal multipliziert werden, das dem zeitlichen Verlauf der Amplitude des Oszillatorsignals entspricht. Ein derartiger Hochfrequenzimpuls hat die Eigenschaft, daß die erforderliche Hochfrequenzspitzenleistung um so größer ist, je dicker der dadurch zu beeinflußende Bereich ist. Aus diesem Grund sind für das bekannte Verfahren relativ hohe Spitzenleistungen erforderlich.

Aufgabe der Erfindung ist es, ein Verfahren der eingangs genannten Art zu schaffen, das mit einer geringeren Hochfrequenzspitzenleistung auskommen kann. Diese Aufgabe wird erfindungsgemäß dadurch gelöst, daß auf einen Träger dessen Frequenz der Larmorfrequenz in der Mitte der zu untersuchenden Schicht entspricht ein Signal moduliert wird, dessen Frequenz sich in einem Bereich ändert, der der Differenz zwischen dieser Larmorfrequenz und den Larmorfrequenzen in einem der Bereiche entspricht.

Bei der Erfindung wird also ein frequenzmodulierter Hochfrequenzimpuls verwendet. Es ist an sich bekannt, daß zur Erzeugung frequenzmodulierter Hochfrequenzimpulse eine niedrigere Spitzenleistung benötigt wird, als zur Erzeugung von amplitudenmodulierten Hochfrequenzimpulsen für den gleichen Flipwinkel (EP-OS 85 200 644.4). Während nämlich die Dauer eines amplitudenmodulierten Hochfrequenzimpulses seiner Bandbreite und damit der Dicke des durch ihn anzuregenden Bereiches umgekehrt proportional ist, kann die Dauer eines frequenzmodulierten Impulses weitgehend unabhängig von der Bandbreite gewählt werden; sie läßt sich daher so groß bemessen, das nur noch eine vergleichsweise niedrige Hochfrequenzspitzenleistung erforderlich ist.

Üblicherweise ist zur Erzeugung eines frequenzmodulierten Hochfrequenzimpulses ein Frequenzmodulator erforderlich. Ein solcher Frequenzmodulator kann - vergl. Fig.5 der EP-OS 85 200 644 - zwei als multiplikative Mischer wirksame Modulatoren enthalten, deren anderem Eingang jeweils ein Signal zugeführt wird, das dem Realteil bzw. dem Imaginärteil des frequenzmodulierten Signales entspricht. Die in den üblichen Kernspinuntersuchungsgeräten vorhandenen Modulatoren besitzen jedoch nur eine einzige multiplikativ wirkende Mischstufe, mit der eine der artige Frequenzmodulation nicht durchgeführt werden kann. Das erfindungsgemäße Verfahren läßt sich jedoch mit einem derartigen Modulator durchführen. Dem liegen folgende Überlegungen zugrunde:

Ein frequenzmodulierter Hochfrequenzimpuls, der in einem der beiden Bereiche beiderseits einer zu untersuchenden Schicht die Kernmagnetisierung vom Rand dieser Schicht bis zum Ende des Empfangs- bzw. des Sendebereichs der Hochfrequenzspule beeinflußt, läßt sich als komplexe Funktion bezüglich der Lamorfrequenz in der Mitte der zu untersuchenden Schicht darstellen. Ein in dieser Darstellung konjugiert komplexer Hochfrequenzimpuls, d.h. ein Impuls mit gleicher Amplitude, gleichem Realteil und invertiertem Imaginärteil würde nun gerade die negativen Frequenzen, bezogen auf die Frequenz in der Mitte der Schicht, durchlaufen. Das heißt, er würde in der entgegengesetzten Richtung einen Bereich vom anderen Rand der Schicht bis zum anderen Ende des Sende- bzw. Empfangsbereiches des Objekts durchlaufen. Wenn der Frequenzabstand zwischen den beiden Rändern der Schicht groß genug ist und die verwendete Hochfrequenzfeldstärke nicht zu groß ist, können beide Hochfrequenzimpulse gleichzeitig auf den Untersuchungsbereich gegeben werden, ohne sich gegenseitig zu beeinflußen. Dies entspricht einer Addition der beiden zueinander konjugiert komplexen Hochfrequenzimpulse bei der sich die Realteile addieren und die Imaginärteile kompensieren. Es ist daher lediglich erforderlich den Realteil des frequenzmodulierten Signals auf den Träger in einem Amplitudenmodulationsvorgang zu modulieren, was mit einem für diese Zwecke üblichen Amplitudenmodulator erfolgen kann.

Der Hochfrequenzimpuls kann sowohl ein $90°$-Hochfrequenzimpuls als auch ein $180°$-Hochfrequenzimpuls sein. Durch einen $90°$-Hochfrequenzimpuls werden die beiden Bereiche beiderseits der Schicht angeregt, während die Schicht selbst nicht angeregt wird. Um die Kernmagnetisierungsverteilung in der Schicht zu untersuchen, muß die Kernmagnetisierung in ·den Bereichen beiderseits der Schicht dephasiert werden und anschließend wenigstens ein nichtselektiver Hochfrequenzimpuls erzeugt werden, der die Kernmagnetisierung im gesamten Hochfrequenzbereich beeinflußt. Da die Kernmagnetisierung außerhalb der Schicht aber bereits dephasiert ist, liefert nur die Schicht selbst einen Beitrag zu dem mit diesem Hochfrequenzimpuls bzw. diesen Hochfrequenzimpulsen verbundenen Kernspinresonanzsignalen.

Die erforderliche Dephasierung in den Bereichen beiderseits der Schicht läßt sich nach einer Weiterbildung der Erfindung besonders leicht dadurch erreichen, daß die Frequenz des Signales so geändert wird, daß der Betrag der Differenz zeitlich zunimmt. Hierbei schreitet die Anregung in den Bereichen von innen nach außen fort. Da während des gesamten Hochfrequenzimpulses ein magnetisches Gradientenfeld anliegt, ist bei dieser Ausführungsform die Kernmagnetisierung unmittelbar beiderseits der Schicht bereits am Ende des Hochfrequenzimpulses dephasiert, so daß das magnetische Gradientenfeld in diesem Fall am Ende des Hochfrequenzimpulses - oder kurz danach - abgeschaltet werden kann.

Eine Anordnung zur Durchführung des erfindungsgemäßen Verfahrens, die versehen ist mit einem Magneten zur Erzeugung eines homogenen stationären Magnetfeldes, einer Gradientenspulenanordnung zur Erzeugung von in Richtung des stationären Magnetfeldes verlaufenden Magnetfeldern mit in verschiedenen Richtungen verlaufenden Gradienten, einer Hochfrequenzspulenanordnung zur Erzeugung eines hochfrequenten, zum stationären Magnetfeld senkrechten Magnetfeldes und einem Hochfrequenzgenerator, der mit der Hochfrequenzspulenanordnung koppelbar ist und einen als multiplikative Mischstufe wirksamen Modulator enthält, ist dadurch gekennzeichnet, daß ein Signalerzeuger vorgesehen ist, der ein frequenzmoduliertes Signal liefert und daß in dem Modulator die Schwingungen eines auf die Larmorfrequenz abstimmbaren Oszillators mit dem Signal multipliziert werden.

Nach einer bevorzugten Weiterbildung ist dabei vorgesehen, daß ein Speicher vorgesehen ist, in den das Signal als Folge digitaler Datenworte gespeichert ist, und daß der Speicher über ein Digital-Analog-Wandler mit einem Eingang des Modulators gekoppelt ist.

Die Erfindung wir nachstehend an Hand der Zeichnungen näher erläutert. Es zeigen:

Fig.1 ein Kernspinuntersunchungsgerät, bei den die Erfindung anwendbar ist,

Fig.2 ein Blockschaltbild eines solchen Gerätes,

Fig.3 die zeitliche Lage verschiedener Signale bei einer Sequenz, bei der die Erfindung anwendbar ist,

Fig.4a die räumliche Zuordnung der Larmorfrequenzen,

Fig.4b den zeitlichen Verlauf der Frequenz bei einem Hochfrequenzimpuls,

Fig.5 eine weitere Sequenz, bei der die Erfindung anwendbar ist.

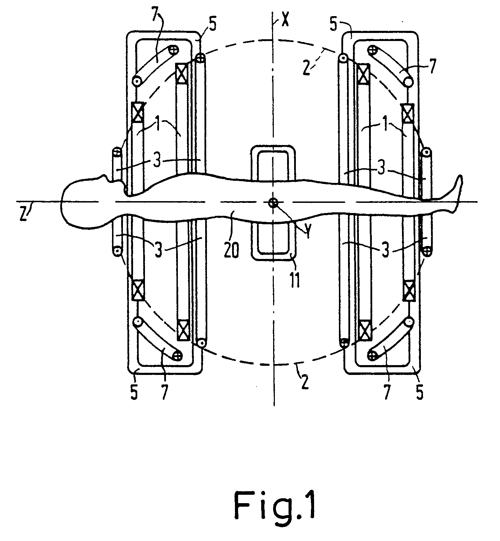

Der in Fig.1 schematisch dargestellte Kernspin-Tomograph enthält ein aus vier Spulen 1 bestehende Anordnung zur Erzeugung eines homogenen stationären Magnetfeldes, das in der Größenordnung von einigen Zehntel T bis einigen T liegen kann. Dieses Feld verläuft in z-Richtung eines kartesischen Koordinatensystems. Die zur z-Achse konzentrisch angeordneten Spulen 1 können auf einer Kugeloberfläche 2 angeordnet sein. Im Inneren dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld Gx erzeugen, dessen Gradient jedoch in x-Richtung verläuft. Ein in z-Richtung verlaufendes magnetsiches Gradientenfeld Gy mit einem Gradienten in y-Richtung wird von vier Spulen 5 erzeugt, die mit den Spulen 7 identisch sein können, die jedoch diesen gegenüber um 90° räumlich versetzt angeordnet sind. Von diesen vier Spulen 5 sind in Fig.1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum das gleichzeitig den Koordinatenursprung des erwähnten kartesischen x, y, z-Koordiantensystem bildet, nur durch das stationäre homogene Magnetfeld der Spulenanordnung 1 bestimmt. Weiterhin ist eine Hochfrequenzspule 11 symmetrisch zur Ebene z = 0 des Koordinatensystems angeordnet, die so ausgebildet ist, das damit ein im wesentlichen homogenes und in x-Richtung, d.h. senkrecht zur Richtung des stationären homogenen Magnetfeldes verlaufendes hochfrequentes Magnet feld erzeugt wird. Der Hochfrequenzspule wird wärend jedes Hochfrequenzimpulses ein hochfrequenter modulierter Strom von einem Hochfrequenzgenerator zugeführt. - Im Anschluß an einen oder mehrere Hochfrequenzimpulse dient die Hochfrequenzspule 11 zum Empfangen der durch Kernspinresonanz im Untersuchungsbereich erzeugten Echosignale. Stattdessen könnte aber auch eine gesonderte Hochfrequenz-Empfangsspule verwendet werden.

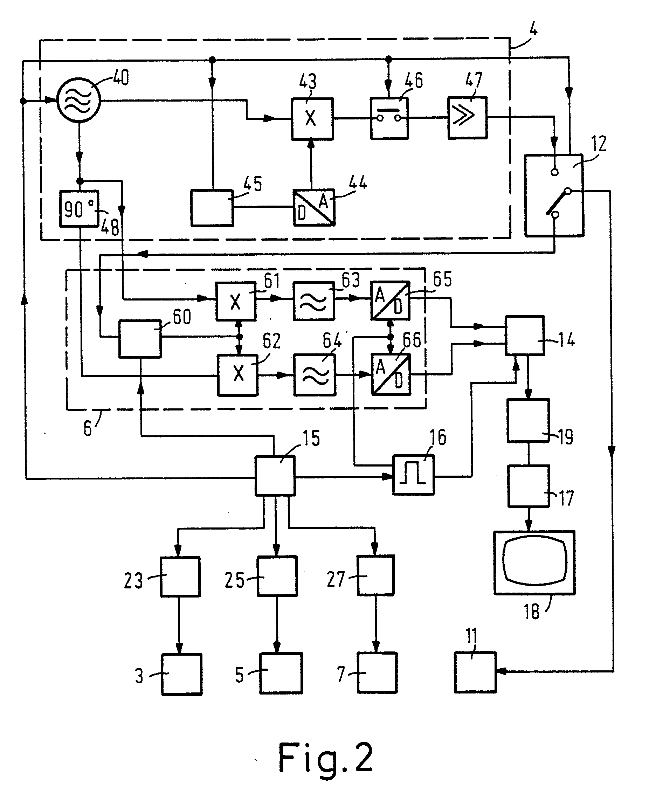

Fig.2 zeigt ein vereinfachtes Blockschaltbild dieses Kernspintomographen. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz digital steuerbaren Hochfrequenzosillator 40, der Schwingungen mit einer Frequenz gleich der Larmorfrequenz derjenigen Atomkerne, deren räumliche Verteilung in der Schicht ermittelt werden soll, bei der von den Spulen 1 erzeugten Feldstärke aufweist. Die Larmorfrequenz f berechnet sich bekanntlich nach der Beziehung f = cB, wobei B die magnetische Induktion in dem stationären homogenen Magnetfeld darstellt und c das gyromagnetische Verhältnis, das beispielsweise für Wasserstoffprotonen 42,56 MHz/T und für das Natriumisotop Na 23 11,26 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Eingang mit einem digitalen Speicher 45 verbunden ist. Aus dem Speicher 45 wird - gesteuert durch eine Steuereinrichtung 15 - eine Folge von ein frequenzmoduliertes Signal darstellenden digitalen Datenworten ausgelesen.

Die multiplikative Mischstufe 43 erzeugt als Ausgangssignal ein dem Produkt der Signale an ihren Eingängen proportionales Signal; das frequenzmodulierte Signal wird also auf den Träger aufmoduliert. Das Ausgangssignal der Mischstufe 43 wird über einen von der Steuereinrichtung 15 gesteuerten Schalter 46 einem Hochfrequenz-Leistungsverstäker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem die in der Hochfrequenzspule 11 induzierten, durch Kernspinresonanz hervorgerufenen Echosignale zugeführt werden, wenn die Umschalteinrichtung 12 entsprechend gesteuert ist. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers 60 ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufe 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90°-Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüber liegenden Frequenzen unterdrückt und niederfrequente Anteile durchlassen, je einem Analog-Digital-Wandler 65 bzw. 66 zugeführt. Dieser setzt die analogen Signale der einen Quadratur-Demodulator bildenden Schaltung 61...64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die drei Spulenanordnungen 3, 5 und 7 werden von Stromgeneratoren 23, 25 und 27 jeweils mit einem Strom versorgt, dessen zeitlicher Verlauf durch die Steuereinheit 15 steuerbar ist. Die im Speicher 14 gespeicherten Datenworte bzw. Abtastwerte werden einem Rechner 17 zugeführt, der daraus die räumliche Verteilung der Kernmagnetisierung in der untersuchten Schicht ermittelt und die ermittelte Verteilung an einer geeigneten Wiedergabeeinheit, z.B. einem Monitor 18, ausgibt.

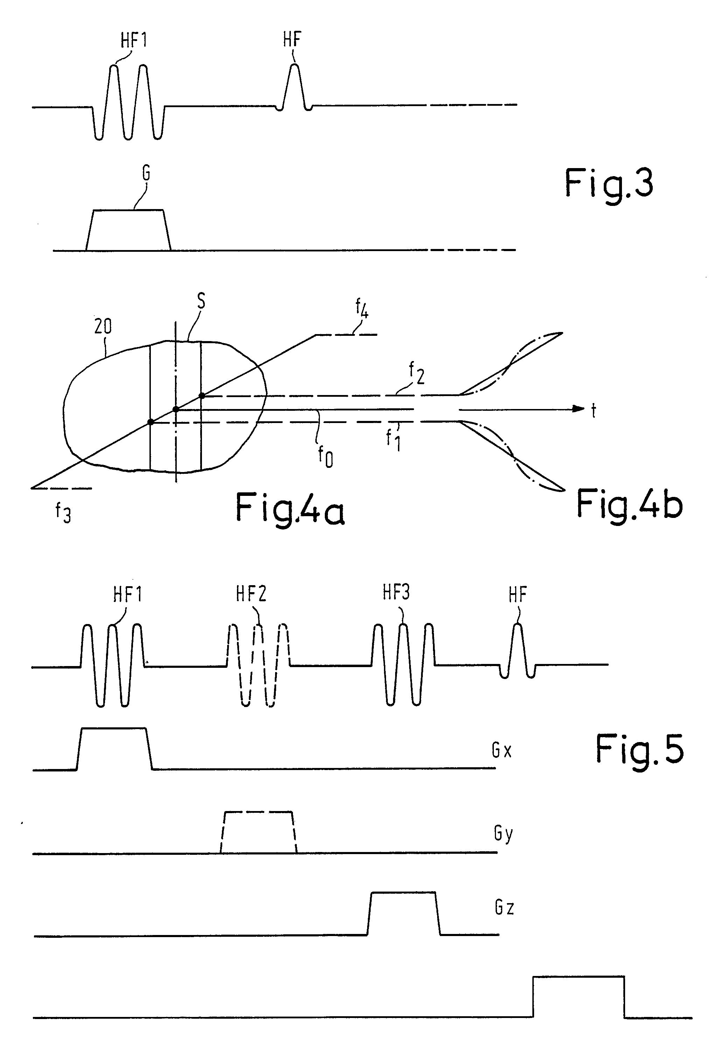

In Fig.3 ist die zeitliche Lage verschiedener Signale bei einem Teil einer Sequenz dargestellt, bei der die Erfindung anwendbar ist. Mit HF1 (erste Zeile) ist dabei ein frequenzmodulierter Hochfrequenzimpuls bezeichnet. Während dieses Hochfrequenzimpulses ist ein magnetisches Gradientenfeld G eingeschaltet (zweite Zeile), beispielsweise dadurch, daß während des Hochfrequenzimpulses der Stromgenerator 23 einen Strom für die Gradientenspulenanordnung 3 liefert. Der Hochfrequenzimpuls HF1, der einen 90°-Hochfrequenzimpuls ist, bewirkt in Verbindung mit dem magnetischen Gradientenfeld G, daß in dem Untersuchungs bereich 20 beiderseits einer durch die Frequenz des Oszillators 40 bestimmten Schicht die Kernmagnetisierung angeregt und dephasiert wird.

Durch einen weiteren Hochfrequenzimpuls HF im Anschluß an den ersten Hochfrequenzimpuls HF1, bei dem kein magnetisches Gradientenfeld eingeschaltet ist, wird die Kernmagnetisierung im gesamten Untersuchungsbreich angeregt. Da die Kernmagnetisierung außerhalb der Schicht aber bereits durch den Hochfrequenzimpuls HF1 dephasiert ist, liefert nur die Kernmagnetisierung innerhalb der Schicht einen Beitrag zu dem nach dem Hochfrequenzimpuls HF auftretenden Kernresonanzsignal. An Stelle des vorzugsweise als 90°-Hochfrequenzimpuls gestalteten Hochfrequenzimpulses HF können auch zwei oder mehrere weitere Hochfrequenzimpulse innerhalb einer Sequenz erzeugt werden. Durch Einschaltung magnetischer Gradientenfelder zwischen oder nach diesen Hochfreqenzimpulsen läßt sich mit einer Vielzahl von Sequenzen mit von Sequenz zu Sequenz geänderten Parametern, die Kernmagnetisierungsverteilung innerhalb der Schicht bestimmen.

Es ist aber auch möglich, innerhalb einer Sequenz zunächst drei aufeinander folgende frequenzmodulierte 90°-Hochfrequenzimpulse zu erzeugen, während jedes dieser Hochfrequenzimpulse ein magnetisches Gradientenfeld mit von Impuls zu Impuls um 90° gedrehter Gradientenrichtung einzuschalten (dadurch wird die Kernmagnetisierung überall außerhalb eines durch die drei aufeinander senkrechten Schichten definierten Volumenbereichs dephasiert) und dann einen nichtselektiven Hochfrequenzimpuls zu erzeugen. Dieser erzeugt ein Kernresonanzsignal, das durch die Kernmagnetisierung - und deren spektrale Verteilung - in dem Volumenelement bestimmt ist.

Fig.4a zeigt das Untersuchungsobjekt 20 und die senkrecht zur Zeichenebene verlaufende Schicht S, die sich ergibt, wenn der Gradient des magnetischen Gradientenfeldes in horizontaler Richtung verläuft. Bei einem konstanten Gradienten ändert sich bekanntlich die Larmorfrequenz in dem durch das Objekt 20 definierten Untersuchungsbereich linear von links nach rechts. Sie beträgt $f_0$ in der Mitte der Schicht S; am linken bzw. am rechten Rand der Schicht beträgt sie $f_1$ bzw. $f_2$. Der linke bzw. rechte Rand des Untersuchungsbereiches liegt innerhalb des durch die Larmorfrequenzen $f_3$ bzw. $f_4$ definierten Bereiches, wobei gelten soll,

$$f_4 - f_2 = f_1 - f_3.$$

In dem Speicher 45 (Fig.2) ist eine Folge von Datenwörtern gespeichert, die bei der durch die Steuereinheit 15 gesteuerten Auslesung des Speicherinhalts und dessen Verarbeitung durch den Digital-Analog-Wandler 44 ein Signal ergibt, dessen Frequenz sich linear von einem ersten Wert, der Differenz $f_2 - f_0$ entspricht bis zu einem zweiten Wert ändert, der der Differenz $f_4 - f_0$ entspricht. Die Änderungsgeschwindigkeit der Frequenz ist dabei so bemessen, daß der angegebene Bereich, während der Dauer (z.B. 5 ms) des Hochfrequenzimpulses HF1 gerade einmal durchlaufen wird.

Da die durch das magnetische Gardientenfeld G bewirkten Änderungen des durch die Spulen 1 erzeugten homogenen stationären Magnetfeldes klein sind im Vergleich zur Feldstärke dieses Magnetfeldes ist die Momentanfrequenz des Ausgangssignals des Digital-Analog-Wandlers 44 klein im Vergleich zur Larmorfrequenz. Dieses Signal kann daher mit verhältnismäßig wenig Datenworten in dem Speicher 45 gespeichert werden, wobei die Umhüllende dieses Signales zweckmäßiger Weise so gewählt wird, wie in der Europäischen Patentanmeldung 85 200 644 beschrieben.

Dieses Signal wird in der Mischstufe 43 mit dem sinusförmigen Signal des auf die Frequenz $f_0$ abgestimmten Oszillators 40 gemischt. Das dem Produkt dieser Eingangssignale proportionale Ausgangssignal der Mischstufe 43 enthält daher eine Komponente, deren Frequenz sich linear von einem Wert $f_2$ zu einem Wert $f_4$ ändert (vergl. Fig.4b) und eine Komponente, deren Frequenzabstand zu $f_0$ sich in gleicher Maße, jedoch in entgegengesetzter Richtung ändert, wie bei der erstgenannten Komponente, d.h. von $f_1$ nach $f_3$. Der damit einhergehende Hochfrequenzimpuls HF1 hat also zur Folge, daß die Larmorfrequenzen zunächst der beiden der Schicht unmittelbar benachbarten Bereiche und dann der weiter entfernt liegenden Bereiche in dem Hochfrequenzimpuls HF1 auftreten. Die dadurch in diesen Bereichen angeregte Kernmagnetisierung wird aber dadurch dephasiert, daß das magnetische Gradientenfeld G über diese Anregung hinaus eingeschaltet bleibt. Die Kernmagnetisierung in den beiderseits der Schicht S befindlichen Teilen des Untersuchungsbereiches ist also dephasiert, wenn das magnetische Gradientenfeld G mit dem Hochfrequenzimpuls HF1 - oder erforderlichenfalls kurz danach - abgeschaltet wird.

Es ist nicht erforderlich, daß die Frequenz sich linear ändert; beispielsweise kann auch eine nach einer Tangens-Hyperbolicus-Funktion verlaufende Frequenzänderung von Nutzen sein, wie sie in Fig.4b mit strichpunktierten Linien angedeutet ist; in diesem Fall sollte die umhüllende des im Speicher 45 gespeicherten Signals mit variabler Frequenz einer Secans-Hyperbolicus-Funktion folgen (J. Chem. Phys. 79, 9 November 1983, Seiten 4643 bis 4644).

Das in Fig.5 dargestellte Verfahren basiert auf dem in J. Magn. Reson. 66, Seiten 283 bis 294 (1986) beschriebenen sogenannten ISIS-Verfahren, bei dem bis zu drei 180° Hochfrequenzimpulse auf einen Untersuchungsbereich einwirken, wobei durch jeden Hochfrequenzimpuls die Kernmagnetisierung in einer von drei zueinander senkrechten Schichten invertiert wird. Durch die Anwendung der frequenzmodulierten Hochfrequenzimpulse wird die Kernmagnetisierung beiderseits der jeweiligen Schicht angeregt, während sie in der Schicht selbst unverändert bleibt. Im einzelnen gilt folgendes:

Das Verfahren umfaßt Sequenzenfolgen mit jeweils acht Sequenzen. Jede Sequenz enthält bis zu drei schichtselektive frequenzmodulierte 180°-Hochfrequenzimpulse HF1, HF2 und HF3, sowie immer einen nichtselektiven Hochfrequenzimpuls HF, der vorzugsweise ein 90°-Impuls ist. Die acht Sequenzen einer Sequenzenfolge enthalten die drei Hochfrequenzimpulse HF1 bis HF3 in den acht möglichen Kombinationen. Eine der acht Sequenzen enthält also keinen der drei Hochfrequenzimpulse, während eine andere alle drei Hochfrequenzimpulse enthält. Je drei der Sequenzen enthalten nur jeweils einen bzw. zwei der Hochfrequenzimpulse in unterschiedlicher Kombination.

Die in Fig.5 dargestellte einzige Sequenz der Sequenzenfolge umfaßt lediglich den Hochfrequenzimpuls HF1 (erste Zeile), der mit dem magnetischen Gradientenfeld Gx (zweite Zeile) verknüpft ist und den mit dem magnetischen Gradientenfeld Gx (vierte Zeile) einen hergehenden Hochfrequenzimpuls HF3. Die Lage des in dieser Sequenz ausbleibenden zweiten Hochfrequenzimpulsrs HF2 und des damit verknüpften magnetischen Gradientenfeldes Gy (dritte Zeile) ist in Fig.5 gestrichelt angedeutet. Dem Impuls HF3 folgt der weitere Hochfrequenzimpuls HF, der den gesamten Untersuchungsbereich anregt und ein Kernresonanzsignal erzeugt, das aus dem gesamten Untersuchungsbereich stammt. Dieses Kernresonanzsignal wird abgetastet, d.h. es wird (vergl. fünfte Zeile) der Impulsgenerator 16 freigegeben. Durch jeden der Hochfrequenzimpulse HF1..HF3 wird die Kernmagnetisierung beiderseits einer Schicht invertiert, die senkrecht auf der Richtung des mit dem Hochfrequenzimpuls verknüpften Gradienten steht. Infolgedessen wird in dem Schnittbereich, der drei zueinander senkrechten Schichten die Kernmagnetisierung durch keinen der Hochfrequenzimpulse invertiert. Für jede andere Stelle des Untersuchungsbereiches wirken vier der Sequenzen invertierend und die vier anderen nichtinvertierend. Addiert man daher die in den acht Sequenzen einer Sequenzenfolge erzeugten Kernresonanzsignale, dann liefert nur nur der erwähnte Schnittbereich einen Beitrag, während die aus den anderen Bereichen herrührenden Anteil der Kernresonanzsignale sich jeweils kompensieren.

Die Hochfrequenzimpulse HF1 und HF3 werden jeweils auf gleiche Weise erzeugt, wie anhand von Fig.3 und 4a und b beschrieben. Jedoch ist ihr Energieinhalt größer, so daß sich ein Flip-Winkel von 180° ergibt. In diesem Fall ist eine Dephasierung der Kernmagnetisierung weder möglich, noch erforderlich; es wird durch die auf diese Weise frequenzmodulierten 180°-Hochfrequenzimpulse lediglich die Kernmagnetisierung jeweils beiderseits einer Schicht invertiert.

## Ansprüche

1. Verfahren zur Bestimmung der Kernmagnetisierungsverteilung, bei dem in Anwesenheit eines homogenen stationären Magnetfeldes mehrere Sequenzen auf einen Untersuchungsbereich einwirken, wobei jede Sequenz einen Hochfrequenzimpuls enthält, durch den in Verbindung mit einem magnetischen Gradientenfeld die Kernmagnetisierung in den beiderseits einer zu untersuchenden Schicht befindlichen Bereichen angeregt und ggf. dephasiert wird, dadurch gekennzeichnet, daß auf einen Träger, dessen Frequenz der Larmorfrequenz in der Mitte der zu untersuchenden Schicht entspricht, ein Signal moduliert wird, dessen Frequenz sich in einem Bereich ändert, der der Differenz zwischen dieser Larmorfrequenz und den Larmorfrequenzen in einem der Bereiche entspricht.

2. Verfahren nach Anspruch 1, dadurch gekennzeichnet, daß die Frequenz des Signales so geändert wird, daß der Betrag der Differenz zeitlich zunimmt.

3. Verfahren nach einem der Ansprüche 1 oder 2, dadurch gekennzeichnet, daß der Hochfrequenzimpuls ein 90°-Hochfrequenzimpuls ist.

4. Verfahren nach einem der Ansprüche 1 oder 2, dadurch gekennzeichnet, daß der Hochfrequenzimpuls ein 180°-Hochfrequenzimpuls ist.

5. Verfahren nach einem der Ansprüche 1 bis 4, dadurch gekennzeichnet, daß die Frequenz sich zeitlich linear ändert.

6. Verfahren nach einem der Ansprüche 1 bis 4, dadurch gekennzeichnet, daß die Frequenz des Signals sich zeitlich nach einer Hyperbeltangens-Funktion ändert.

7. Anordnung zur Durchführung des Verfahren nach Anspruch 1, mit einem Magneten zur Erzeugung eines homogenen stationären Magnetfeldes, einer Gradientenspulenanordnung zur Erzeugung von in Richtung des stationären Magnetfeldes verlaufenden Magnetfeldern, mit in verschiedenen Richtungen verlaufenden Gradienten, einer Hochfrequenzspulenanordnung zur Erzeugung eines hochfrequenten zum stationären Magnetfeld senkrechten Magnetfeldes und einem Hochfrequenzgenerator, der mit der Hochfrequenzspulenanordnung koppelbar ist und einen als multipikative Mischstufe wirksamen Modulator enthält, dadurch gekennzeichnet, daß ein Signalerzeuger (44,45) vorgesehen ist, der ein frequenzmoduliertes Signal liefert, und daß in dem Modulator die Schwingungen eines auf die Larmorfrequenz abstimmbaren Oszillators mit dem Signal multipliziert werden.

8. Anordnung nach Anspruch 7,
dadurch gekennzeichnet, daß der Signalerzeuger einen Speicher (45) enthält, in dem das Signal als Folge digitaler Datenworte gespeichert ist, und einen Digital-Analog-Wandler (44), über den der Speicher (45) mit einem Eingang des Modulators (43) gekoppelt ist.

# Fig.1

Fig.2

Fig.3

Fig.4a

Fig.4b

Fig.5